# EUROPEAN PATENT APPLICATION

(11) **EP 4 009 358 A1**
(43) Date of publication of application: **08.06.2022**
(21) Application number: 21211688.3
(22) Date of filing: 01.12.2021
(51) Int. Cl.: H01L 21/687

(54) **HIGH PERFORMANCE SUSCEPTOR APPARATUS**

(30) Priority: 04.12.2020 US 202063121651 P
(71) Applicant: ASM IP Holding B.V., Almere, 1322 AP (NL)
(72) Inventor: GAO, Peipei, 1322 AP Almere (NL); WANG, Wentao, 1322 AP Almere (NL); LIN, Xing, 1322 AP Almere (NL); YE, Han, 1322 AP Almere (NL); CHAO, Ion Hong, 1322 AP Almere (NL); GAO, Fan, 1322 AP Almere (NL); LUAN, Siyao, 1322 AP Almere (NL); DEMOS, Alexandros, 1322 AP Almere (NL)
(74) Representative: V.O.

(57) **Abstract**

A substrate support and lift assembly configured to support and lift a substrate from a susceptor is disclosed. The substrate support and lift assembly can include a susceptor support and a lift pin. The susceptor support can be configured to support the susceptor thereon. The susceptor support includes a plurality of support arms each extending radially from a central portion of the susceptor support to a terminus. Each of the plurality of support arms includes an aperture extending therethrough. The lift pin can be configured to fit through the aperture of a corresponding support arm to lift a substrate on the susceptor.

## Description

### CROSS-REFERENCE TO RELATED APPLICATIONS

This application claims the benefit of priority to U.S. Provisional Application No. 63/121,651, filed December 4, 2020, titled HIGH PERFORMANCE SUSCEPTOR APPARATUS, which is hereby incorporated by reference herein in its entirety. Any and all applications for which a foreign or domestic priority claim is identified in the Application Data Sheet as filed with the present application are hereby incorporated by reference under 37 CFR 1.57.

### BACKGROUND

### Field of the Invention

This disclosure relates generally to semiconductor processing, and more particularly to susceptors for supporting semiconductor substrates in processing chambers.

### Description of the Related Art

Semiconductor substrates, such as semiconductor wafers, are typically processed within a processing chamber under controlled process conditions, including exposure to elevated temperatures. A substrate support, which is commonly referred to as a "susceptor," is usually used to support the substrate during processing (e.g., during a deposition) in the processing chamber. To facilitate automated processing, a robotic arm may be employed to place a substrate on a susceptor and subsequently, after processing, to remove it from the reactor. The susceptor may be supported by support arms of a spider.

A number of quality control issues related to the physical interaction between the substrate and the susceptor may arise during processing, and there is a continuing need to address these quality control issues.

### SUMMARY

Various examples of susceptors for supporting semiconductor substrates and related processing systems and methods are disclosed.

In some embodiments, a substrate support and lift assembly configured to support and lift a substrate from a susceptor is disclosed. The substrate support and lift assembly includes a susceptor support and a lift pin. The susceptor support is configured to support the susceptor thereon. The susceptor support includes a plurality of support arms each extending radially from a central portion of the susceptor support to a terminus. Each of the plurality of support arms includes an aperture extending therethrough. The lift pin is configured to fit through the aperture of a corresponding support arm of the plurality of support arms to lift a substrate..

In some embodiments, a substrate support assembly is disclosed. The substrate support assembly includes a susceptor and a susceptor support. The susceptor is configured to support a substrate thereon. The susceptor includes a plurality of holes each configured to receive a corresponding lift pin therethrough. The susceptor support is configured to support the susceptor and includes a plurality of support arms each extending radially from a central portion of the susceptor support. Each of the plurality of support arms includes an aperture. Each aperture is aligned with a corresponding hole of the susceptor.

In some embodiments, a substrate support assembly is disclosed. The assembly includes a susceptor and a susceptor support. The susceptor is configured to support a substrate. The susceptor includes a plurality of holes extending through a thickness of the susceptor. Each hole is configured to receive a corresponding lift pin therethrough. The susceptor support is configured to support the susceptor thereon. The susceptor support includes a plurality of support arms that each extend radially from a central portion of the susceptor support. Each of the plurality of support arms include an aperture. The susceptor and the susceptor support, and each of the apertures of the plurality of support arms and each of the corresponding holes of the susceptor, are configured to cooperate with each other such that a corresponding lift pin, when extended through the aperture and the hole, does not contact the susceptor at more than a first point of contact.

In some embodiments, a substrate support and lift assembly is disclosed. The substrate support and lift assembly includes a susceptor and a susceptor support. The susceptor includes a plurality of holes, and each hole is configured to receive a lift pin from a lift mechanism. The susceptor support configured to support the susceptor thereon, the susceptor support comprising a plurality of support arms each extending radially from a central portion of the susceptor support, each of the plurality of support arms comprising a support pad configured to extend toward and support the susceptor, each of the support pads disposed radially outward of each of the plurality of holes of the susceptor.

In some embodiments, a susceptor support configured to support a susceptor thereon is disclosed. The susceptor support includes a plurality of support arms and a plurality of support pads. Each of the plurality of support arms extends radially from a central portion of the susceptor support to a terminus, and each of the plurality of support arms includes an aperture extending therethrough. The aperture is configured to receive a corresponding lift pin. Each of the plurality of support pads is attached to a corresponding support arm and is configured to extend toward and support the susceptor. Each of the support pads is disposed radially outward of each of the plurality of holes of the susceptor.

In some embodiments, a susceptor configured to support a substrate is disclosed. The susceptor includes a plurality of holes and a plurality of support pad interfaces. The plurality of holes extend through a thickness of the susceptor, and each is configured to receive a corresponding lift pin therethrough. The plurality of support pad interfaces are each disposed on a lower surface of the susceptor and radially outward from the plurality of holes. The interfaces are configured to engage with a support pad on a susceptor support.

In some embodiments, a substrate support and lift assembly is disclosed. The substrate support and lift assembly includes a susceptor and a susceptor support. The susceptor is configured to support a substrate thereon. The susceptor support is configured to support the susceptor thereon. The susceptor support includes a plurality of support arms that each extend radially from a central portion of the susceptor support. Each of the plurality of support arms is configured to support the susceptor at corresponding support couplings, and each of the support couplings is disposed more than 90 mm from a center of the susceptor.

### BRIEF DESCRIPTION

Figure 1 shows a side view of an example substrate support and lift assembly, according to one embodiment.
Figure 2 shows a top view of the example substrate support and lift assembly of Figure 1, according to one embodiment.
Figure 3 shows a cross-section of a side view of a portion of the substrate support and lift assembly shown in Figure 1.
Figure 4 shows a bottom view of the susceptor, according to one embodiment.
Figure 5 shows how an angled lift pin contacts a susceptor at two contact points.
Figure 6 shows how an angled lift pin contacts a susceptor at a single contact point.
Figure 7 shows a side view of another example substrate support and lift assembly, according to one embodiment.
Figure 8 shows a top view of the example substrate support and lift assembly of Figure 7, according to one embodiment.
Figure 9 shows a cross-section of a side view of a portion of the substrate support and lift assembly shown in Figure 7.
Figure 10 shows a cross-section of a different view of the portion of the substrate support and lift assembly shown in Figure 9, rotated about 60 degrees relative to the view shown in Figure 9.
Figure 11 shows a bottom view of the susceptor shown in Figure 7.

### DETAILED DESCRIPTION

High-temperature ovens, or reactors, are used to process substrates for a variety of reasons. In the electronics industry, substrates, such as semiconductor wafers, are processed to form integrated circuits. In a reaction process, a substrate, typically a circular silicon wafer, is placed on a substrate holder. In some processes, the substrate holder helps to attract radiation and more evenly heat the substrate. These substrate holders are sometimes referred to as susceptors. The substrate and substrate holder are enclosed in a reaction chamber, typically made of quartz, and heated to high temperatures, typically by a plurality of radiant heat lamps placed around the quartz chamber. Other methods are possible.

In an exemplary high temperature process, a reactant gas is passed over the heated substrate, causing the chemical vapor deposition ("CVD") of a thin layer of the reactant material onto a surface of the substrate. As used herein, the terms "processing gas," "process gas," and "reactant gas" generally refer to gases that contain substances, such as silicon-containing gases, to be deposited on a substrate. As used herein, these terms do not include cleaning gases. Through subsequent processes, the layers of reactant material deposited on the substrate are made into integrated circuits. The process gas flow over the substrate is often controlled to promote uniformity of deposition across the top or front side of the substrate. Deposition uniformity can be further promoted by rotating the substrate holder and substrate about a vertical center axis during deposition. The "front side" or "face" of a substrate may refer to the substrate's top surface, which typically faces away from the substrate holder during processing, and the "backside" of a substrate refers to the substrate's bottom surface, which typically faces the substrate holder during processing.

There are a large variety of different types of substrate holders for supporting a substrate during processing. A typical substrate holder comprises a body with a generally horizontal upper surface that receives and/or underlies the supported substrate. A spacer or spacer means may be provided for maintaining a small gap between the supported substrate and the horizontal upper surface of the substrate holder. This gap prevents process gases from causing the substrate to stick to the substrate holder. The substrate holder may include an interior portion that supports the substrate from below and an annular shoulder that closely surrounds the supported substrate. One type of spacer or spacer means comprises a spacer element fixed with respect to the substrate holder body, such as an annular lip, a plurality of small spacer lips, spacer pins or nubs, etc. An alternative type of spacer element comprises a plurality of vertically movable lift pins that extend through the substrate holder body and are controlled to support the position of the substrate above the upper surface of the substrate holder. Often, the spacer element is positioned to contact the substrate only within its "exclusion zone," which is a radially outermost portion of the substrate within which it is difficult to maintain deposition uniformity. The exclusion zone is typically not used in the manufacturing of integrated circuits for commercial use, due to the non-uniformity of deposition there. A processed substrate may be characterized, for example, as having an exclusion zone of five millimeters from its edge.

A number of problems can arise with CVD processes. For example, one problem associated with CVD can occur during the transfer of the wafer to and from the spider. Existing low mass susceptors have pin lift systems that cause a lift pin binding issue that may occur, for example, when the lift pin raises the substrate. When the substrate exhibits bowing, it can exert excessive force on the lift pins, which may lead to pin tilting and/or pin binding. Pin binding can refer to when a pin binds to the backside of the substrate. In some cases, this may result in the support and lift system colliding with the susceptor and/or substrate, which can damage the lift pin during wafer loading and unloading. Another problem arises when the substrate exhibits roll down or roll up near an edge of the substrate. This may particularly occur with patterned substrates due to a gas and/or thermal edge effect during processing.

In existing designs, lift pins can contact the susceptor at two contact points within the susceptor lift pin holes, when the pins move to a certain tilting angle. This contact can result in pin binding due in part to the higher friction between the lift pin and the susceptor during substrate loading and unloading. This may be especially true when the lift pin spider is not well leveled during installation, when a pre-coat thickness is greater than 0.3 µm, when the wafer exhibits excessive bowing during wafer load/unload, and/or in other instances.

One method for solving the issues describe above involves supporting the susceptor with the spider at a point closer to the edge of the susceptor. This can increase the minimum friction force needed to inadvertently lift up the susceptor. Additionally or alternatively, the susceptor and susceptor support can be configured to allow the lift pins only a single point of contact on the susceptor. This can reduce the likelihood that the susceptor is inadvertently lifted up. This may additionally or alternatively may modify a tilt angle of the lift pins during raising of the substrate. Other details for implementing these solutions are described in more detail below.

Reference will now be made to the figures, in which like numerals generally refer to like parts throughout. It will be appreciated that the figures are not necessarily to scale. It will further be appreciated that the apparatuses may vary as to configuration and as to details of the parts, and that the methods may vary as to the specific steps and sequence, without departing from the basic concepts as disclosed herein.

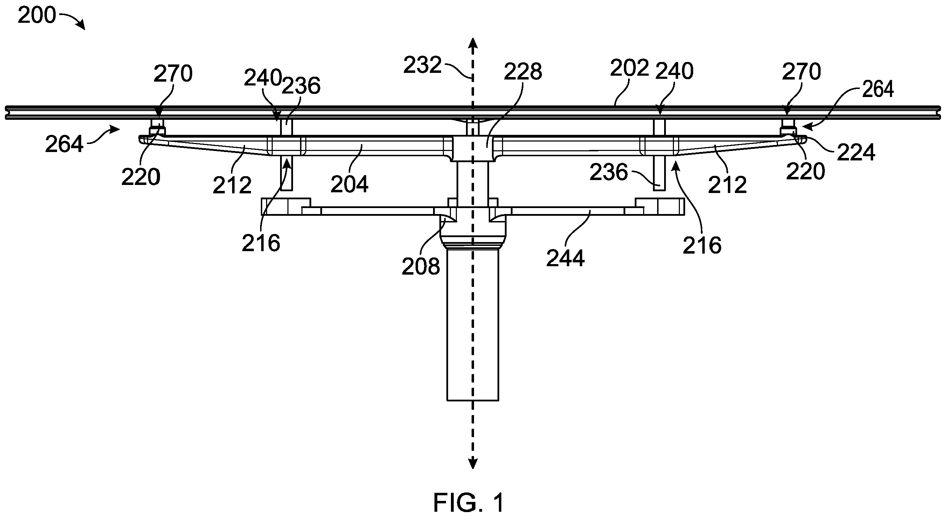

Figure 1 shows a side view of an example substrate support and lift assembly 200, according to one embodiment. As shown, the substrate support and lift assembly 200 includes a susceptor 202, a susceptor support 204 (e.g., a spider), and a lift mechanism 208. The susceptor 202 is configured to receive a substrate (e.g., wafer) thereon, not shown in Figure 1.

The susceptor 202 may be formed in different shapes, but many are circular. The susceptor 202 may comprise one or more materials, such as elemental or molecular materials. Such materials can include non-oxide ceramics, such as silicon carbide (SiC or CSi), graphite, or any other ceramic. Other materials may be used, such as metal. In some embodiments, the susceptor 100 may include a silicon carbide coating, such as silicon-carbide-coated graphite. In some embodiments, the susceptor 202 is formed by machining graphite into a desired shape and by applying a silicon carbide (SiC) coating. Susceptors may be designed to support substrates that are between about 220 mm and about 380 mm in diameter. Such susceptors may have a marginally larger diameter to support the substrate. However, in some embodiments, a susceptor 202 having a larger diameter than these other designs can improve edge temperature uniformity. For example, it has been determined that a diameter of greater than about 280 mm to about 390 mm may promote improved edge thermal uniformity on the susceptor 202 and therefore improve far edge film uniformity. Thus, the susceptor 202 may have a diameter of greater than about 300 mm, such as greater about 360 mm, about 365 mm, about 370 mm, about 375 mm, about 380 mm, about 385 mm, about 390 mm, about 395 mm, about 400 mm, any diameter therein, or fall within a range having endpoints therein.

The substrate support and lift assembly 200 may be disposed within a processing chamber. The processing chamber may allow for conducting the CVD process therein. A drive shaft (not shown) may enter the processing chamber through an opening in the bottom of the chamber. The upper end of the drive shaft can articulate (e.g., raise and lower) the lift mechanism 208 within the substrate support and lift assembly 200 along the central axis 232 within the central portion 228 of the substrate support and lift assembly 200. Additionally or alternatively, the drive shaft can rotate the susceptor support 204 and/or the lift mechanism 208.

The susceptor support 204 can include a plurality of support arms 212. As shown, the lift mechanism 208 includes three support arms 212 (e.g., at least three, for substrate stability, and in some embodiments, exactly three), but other numbers are possible. The support arms 212 each extend radially from a central hub or central portion 228 to a terminus 224. The central portion 228 is disposed about a central axis 232 that extends vertically. Thus, reference to "axial" or "vertical" herein are with reference to the central axis 232. Each of the support arms 212 may be offset from each other at an angle (e.g., circumferentially) around the central axis 232. The angular spacing between any two support arms can be the same or different relative to the spacing between any two other support arms, but is equal (about 120 degrees) as shown.

Each of the support arms 212 comprises an aperture 216 disposed between the central portion 228 and the terminus 224. Each aperture 216 extends vertically through the corresponding support arm 212 to allow a corresponding lift pin 236 to pass therethrough. As discussed above, supporting the susceptor 202 nearer an edge thereof can promote a higher minimum friction needed to inadvertently move or lift the susceptor 202, which can reduce the likelihood of pin binding to the susceptor 202. The aperture 216 can allow the support arms 212 to support the susceptor 202 at a position radially outward of where the lift pins 236 support the substrate. It has been determined that this arrangement may reduce the likelihood of substrate damage during loading and/or unloading of the substrate as the likelihood of pin binding has been reduced. The aperture 216 may be disposed nearer to the edge of the susceptor 202 than to the central axis 232. Additionally or alternatively, the aperture 216 may be disposed nearer to the corresponding support pad 220 than to the edge of the susceptor 202.

The support arms 212 may each further include a support pad 220. The support pad 220 can be disposed, for example, near the terminus 224 of the support arm 212. The support pad 220 may be configured to couple with a corresponding support pad interface 270 of the susceptor 202 at a support coupling 264. The support coupling 264 represents a location at which the support pad 220 couples with (e.g., contacts) the support pad interface 270. The support pad interface 270 may include any type of interface, such as a recess. The recess can extend partially into or completely through the susceptor 202. The recess can comprise a circular shape, or other shapes, such as an elongated slot. The support pad interfaces 270 may be configured to promote self-centering or other self-alignment of the substrate support and lift assembly 200 during processing. Additionally or alternatively, the support pad interfaces 270 may be configured to promote improved coupling with the corresponding support pads 220 with thermal expansion during substrate processing. The support pad interfaces 270 can be configured to control the amount of rotation, tilting, or other movement of the susceptor. For example, the support pad interfaces may be configured to prevent undesirable susceptor rotation during intentional substrate transfer, and/or may allow desirable susceptor movement (e.g., rotation) during processing.

The support pad 220 and the corresponding support coupling 264 and support pad interface 270 may be disposed radially nearer to an edge of the susceptor 202 than to the aperture 216. Additionally or alternatively, the support pad 220 (and the corresponding support coupling 264) may be disposed radially nearer to an edge of the susceptor 202 than to the central axis 232. In some examples, the support pad 220 (and the corresponding support coupling 264) is disposed nearer to the aperture 216 than to the central axis 232. The support pad 220 and the corresponding support coupling 264 and support pad interface 270 can be positioned at a further radial position from the central axis 232 than the aperture 216.

The support pads 220 may comprise protrusions extending from the corresponding support arm 212 to support the susceptor 202. For example, the protrusions can extend axially (e.g. in the general direction of axis 232) from the corresponding support arm 212 towards the susceptor 202. The support pad 220 may comprise silicon carbide (SiC), such as a SiC coating. As noted above, the support pads 220 can be configured to interface with corresponding support pad interfaces 270 of the susceptor 202. The support pad 220 can be configured to reduce the friction force between the susceptor support 204 and the susceptor 202. For example, the frictional force may be reduced (relative to other designs such as designs without a SiC coating) by about 5%, by about 10%, by about 15%, by about 20%, any value therein, or fall within any range having endpoints therein. This reduced friction may allow for easier self-adjustment by forming a SiC/SiC interface (in some embodiments).

With further reference to Figure 1, the lift mechanism 208 can include one or more lift pin supports 244. Each of the lift pin supports 244 can extend radially from the central portion 228 of the substrate support and lift assembly 200. In some embodiments, the lift mechanism 208 includes three or more (e.g., exactly three lift pin supports 244), but other numbers are possible. The assembly 200 can have the same or different number of lift pin supports as support arms. Each lift pin support 244 can support (e.g., press against) a corresponding lift pin 236 that is configured to pass through a corresponding hole 240 within the susceptor 202 to support and/or lift the substrate. Each lift pin 236 may be configured to pass through both a corresponding aperture 216 of the support arm 212 and hole 240 of the susceptor 202.

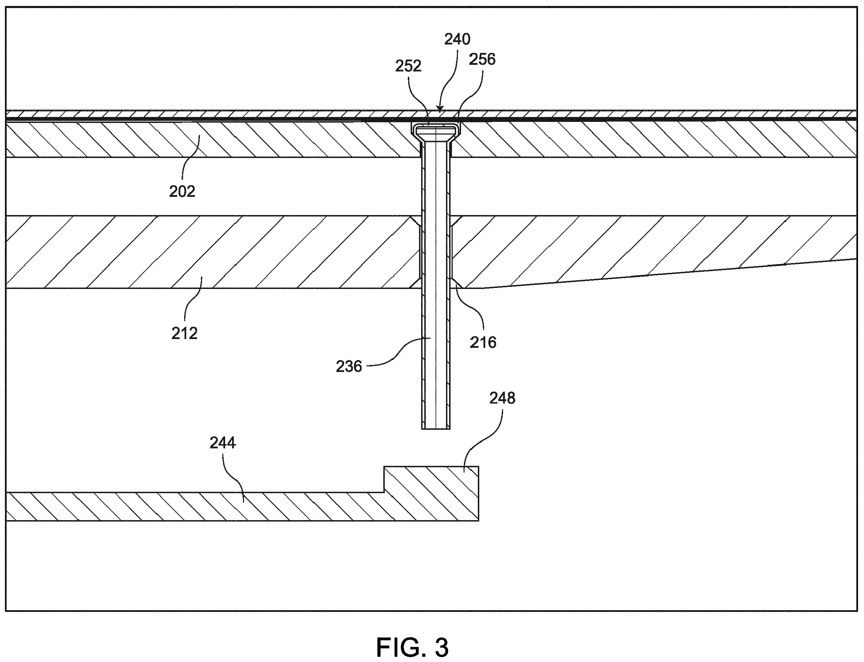

The lift pins 236 can be substantially cylindrical and may be configured to hang from the corresponding holes 240. This is shown in more detail in Figure 3. However, in some embodiments each lift pin 236 is coupled (e.g., attached) to the corresponding lift pin support 244. The lift pins 236 can be coated with a highly thermally conductive material, such as silicon carbide (SiC). The lift pin base can be comprised of a different material, such as graphite. The lift pins 236 may be substantially hollow (e.g., with a cavity within its outer shell, and with one or both ends open or closed). For example, in some embodiments, the lift pins 236 can be coated in SiC and then hollowed by etching using one or more of H2 and/or O2 gas. Because many process results vary as a function of temperature (e.g., the amount of deposited material may vary depending on local temperature variations across the substrate), temperature nonuniformities across the substrate may impact the uniformity of process results across the substrate. Thus, these measures can achieve a similar thermal profile on the substrate as a solid lift pin with a larger diameter.

The susceptor support 204 and lift mechanism 208 can operate in cooperation with each other. The drive shaft (not shown) can articulate (e.g., raise, lower) the lift mechanism 208 relative to the susceptor support 204. The drive shaft may rotate the susceptor support 204 and/or the lift mechanism 208. As the drive shaft rotates the susceptor support 204, the support arms 212 may be rotated as well. Additionally or alternatively, as the drive shaft rotates the lift mechanism 208, the lift pin supports 244 may be rotated as well. For example, the lift mechanism 208 and the susceptor 204 may be concurrently rotated, such that the lift pin supports 244 and the support arms 212 are positioned (e.g., aligned) to allow the lift pins 236 to be moved by the lift pin supports 244, as described elsewhere herein. The control of the support arms 212 and the support pad interfaces 270 may provide a positive coupling means for effecting the rotational movement of the susceptor 202, and maintaining concentricity of the susceptor support 204 and the susceptor 202 during thermal expansions.

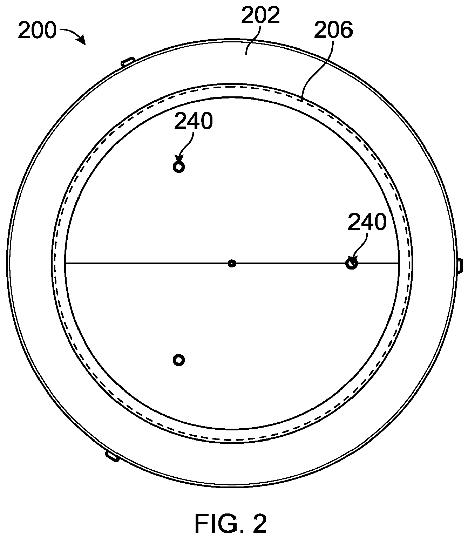

Figure 2 shows a top view of the example substrate support and lift assembly 200 of Figure 1, according to one embodiment. The substrate support and lift assembly 200 is shown with the substrate 206 supported by the susceptor 202. As shown, the face of the susceptor 202 may be in the form of a disc. Other shapes are possible. Figure 2 shows the susceptor 202 optionally having the substrate 206 thereon, as shown by the broken line. The holes 240 of the susceptor 202 can be seen.

Figure 3 shows a cross-section of a side view of a portion of the substrate support and lift assembly 200. A portion of the susceptor 202 and of the support arm 212 can be seen. The cross section shows an example of the positioning and interplay between each of the aperture 216 of the support arm 212 as well as the hole 240 of the susceptor 202 described above. The hole 240 can be shaped to allow the lift pin 236 to fit therethrough. The hole 240 and lift pin 236 can be configured to allow the lift pin head 252 to rest on a lift pin head slot 256 within the hole 240, to prevent movement in one direction (e.g., downwardly). The cross section of the lift pin head slot 256 may include a tapered section between a wider section and a narrower section. The narrower section may be disposed vertically below the wider section to allow the lift pin 236 to hang within the hole 240 when the lift pin 236 is not engaged with the lift pin support 244. The lift pin support 244 can include a lift pin support member 248 at or near a terminus of the lift pin support 244. The lift pin support member 248 can include a corresponding portion that is configured to support (e.g., press against) the lift pin 236 thereon, such as the raised platform shown near the end of the lift pin support 244.

As shown, corresponding holes 240 and apertures 216 can be configured with respect to each other so that the lift pin 236 may pass through both of them simultaneously. For example, the corresponding holes 240 and apertures 216 can be aligned with respect to each other, through similar sizing and/or shape, and/or alignment along a common central axis. As described above, this feature can allow the support arm 212 to support the susceptor 202 at a position which is more radially outward than in current technologies.

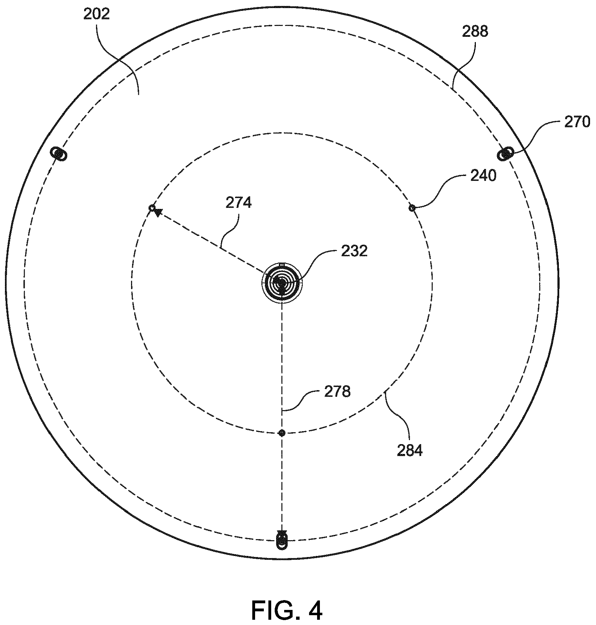

Figure 4 shows a bottom view of the susceptor 202, according to one embodiment. Support pad interfaces 270 are shown near an edge of the susceptor 202. As described above, the support pad interfaces 270 are configured to receive corresponding support pads 220. As shown, in some embodiments corresponding holes 240 and support pad interfaces 270 are collinear with respect to each other along a radius extending from the center axis of the susceptor 202. The support pad interfaces 270 are shown nearer to the edge of the susceptor 202 than to either the corresponding holes 240 or to the center of the susceptor 202, and otherwise positioned as described above with reference to Figures 1-3. Additionally or alternatively, the holes 240 may be disposed nearer to the support pad interfaces 270 than to either the edge of the susceptor or to the center of the susceptor 202 in certain embodiments.

As shown, a support radius 278 (e.g., the distance from the center axis 232 of the susceptor 202 to a support pad interface 270) may be greater than a lift radius 274 (e.g., the distance from the center of the susceptor 202 to a hole 240). For convenience, a corresponding lift circle 284 and support circle 288 are shown, with a lift diameter and support diameter corresponding to twice the lift radius 274 and support radius 278, respectively. As noted above, it has been determined that certain arrangements where the support couplings are at locations radially outward of susceptor holes may reduce the likelihood of substrate damage during loading and/or unloading of the substrate as the likelihood of pin binding has been reduced. Thus, for example, some designs have included a support diameter of between about 100 mm (e.g., a support radius 278 of about 50 mm) and about 250 mm (e.g., a support radius 278 of about 125 mm). However, diameters are possible. For example, the support diameter may be about 190 mm, about 200 mm, about 210 mm, about 220 mm, about 230 mm, about 240 mm, about 250 mm, about 260 mm, about 270 mm, about 280 mm, about 290 mm, about 300 mm, about 310 mm, about 320 mm, about 330 mm, about 340 mm, about 350 mm, about 360 mm, about 370 mm, about 380 mm, about 390 mm, about 400 mm, be any diameter having a value therebetween, or have a value falling within a range having endpoints therein.

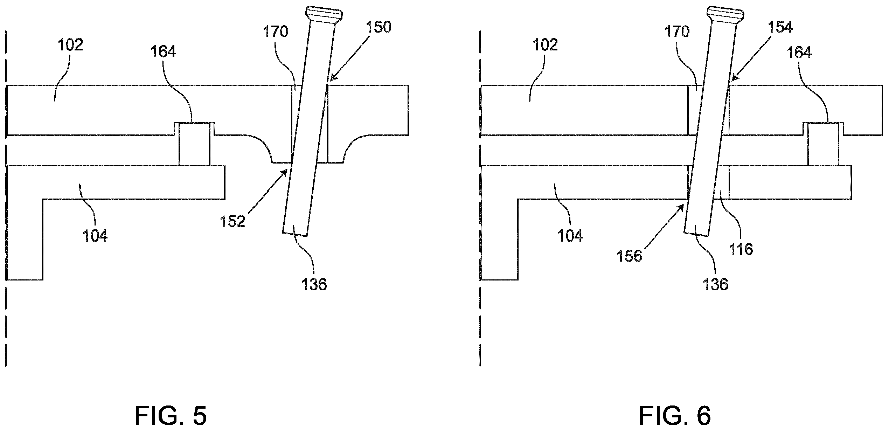

Figure 5 and Figure 6 show comparisons of how an angled lift pin 136 contacts a susceptor 102 according to how the susceptor support 104 is arranged. As noted above, reducing the number of contact points between the lift pins and the susceptor can reduce inadvertent raising of the susceptor by an angled lift pin during transport of the substrate. In Figure 5, the lift pin 136 passes through only the susceptor 102 (via a hole 170), whereas in Figure 6 the lift pin 136 passes through both the susceptor 102 (via the hole 170) as well as the susceptor support 104 (via an aperture 116). Figure 5 shows an embodiment where the susceptor support 104 contacts the susceptor 102 at a support coupling 164 that is radially inward of the hole 170. Figure 6 shows an embodiment (such as the one shown in Figure 3) where the susceptor support 104 contacts the susceptor 102 at a support coupling 164 that is radially outward of the hole 170 and in which the aperture 116 is provided through which the lift pin 136 may pass.

In Figure 5, the lift pin 136 contacts the susceptor 102 at two points of contact 150, 152 when the lift pin 136 is angled sufficiently. The first contact point 150 occurs near a top portion of the susceptor 102, whereas the second contact point 152 occurs near a bottom portion of the susceptor 102. By contrast, in Figure 6 the angled lift pin 136 contacts the susceptor 102 only at a first contact point 154. A second contact point 156 is with the susceptor support 104, not with the susceptor 102. Thus, in certain embodiments where a support coupling 164 is disposed radially outward of the hole 170, the angled lift pin 136 may contact the susceptor 102 at a single contact point (e.g., first contact point 154).

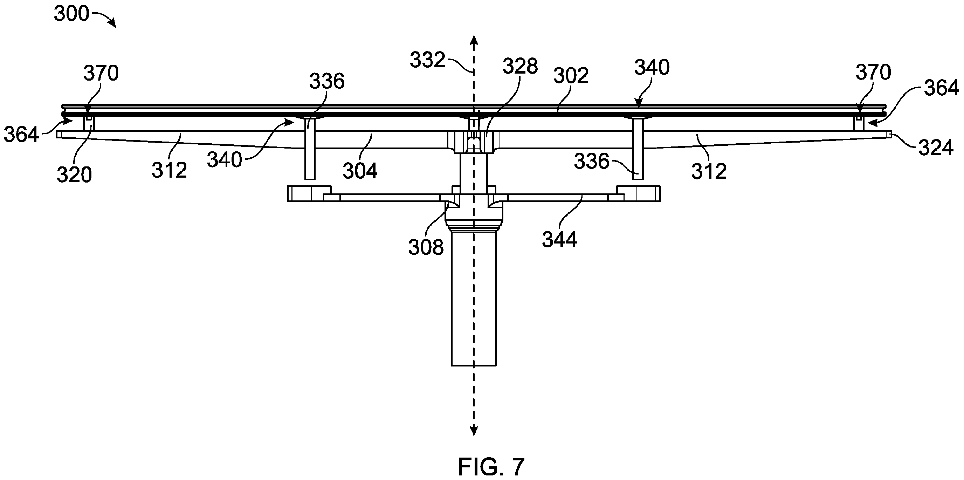

Figure 7 shows a bottom perspective view of another example substrate support and lift assembly 300, according to one embodiment. The substrate support and lift assembly 300 shares many features of the substrate support and lift assembly 200 shown in Figure 1 and described above, with some differences. The substrate support and lift assembly 300 includes a susceptor support 304 that supports the susceptor 302. The substrate support and lift assembly 300 further includes a lift mechanism 308 that is configured to support and lift a substrate (not shown in Figure 7) from the susceptor 302. The susceptor 302, the susceptor support 304, and the lift mechanism 308 are all centered about and coaxial along a central axis 332.

The susceptor support 304 includes a plurality (e.g., three, four, or more) of support arms 312, and in some embodiments exactly three. Each support arm 312 extends from the central portion 328 to the corresponding terminus 324. Near the terminus 324 of each support arm 312 is a support pad 320 extending vertically from the support arm 312 and configured to support the susceptor 302 thereon. As shown, there are no apertures in the support arms 312 like there are in the support arms 212 of Figure 1. This is in part because the support pads 320 are not collinear with respect to each other along a radius extending from the center axis of the susceptor 302. Instead, the support pads 320 and the corresponding lift pins 336 may be angularly offset from one another. Thus, the lift pins 336 do not need to pass through the corresponding support arms 312.

The support pad 320 may be configured to couple with a corresponding support pad interface 370 at a support coupling 364. The support coupling 364 represents a location at which the support pad 320 couples with (e.g., contacts) the support pad interface 370. The support pad interface 370 may include any type of interface, such as a recess. The recess can extend partially into or completely through the susceptor 302. The recess can comprise a circular shape, or other shapes, such as an elongated slot. As with the support pad interfaces 270 described above with respect to Figure 1, the support pad interfaces 370 may be configured to promote self-centering or other self-alignment of the substrate support and lift assembly 300 during processing. Additionally or alternatively, the support pad interfaces 370 may be configured to promote improved coupling with the corresponding support pads 320 with thermal expansion during substrate processing. The support pad interfaces 370 can be configured to control the amount of rotation, tilting, or other movement of the susceptor. For example, the support pad interfaces may be configured to prevent undesirable susceptor rotation during intentional substrate transfer, and/or may allow desirable susceptor movement (e.g., rotation) during processing.

The support pad 320 and the corresponding support coupling 364 and support pad interface 370 may be disposed radially nearer to an edge of the susceptor 302 than to the aperture 316. Additionally or alternatively, the support pad 320 (and the corresponding support coupling 364) may be disposed radially nearer to an edge of the susceptor 302 than to the central axis 332. In some examples, the support pad 320 (and the corresponding support coupling 364) is disposed nearer to the aperture 216 than to the central axis 332. The support pad 320 and the corresponding support coupling 364 and support pad interface 270 can be positioned at a further radial position from the central axis 332 than the aperture 316.

The support pads 320 may comprise protrusions extending axially from the corresponding support arm 312 to support the susceptor 302. For example, the protrusions can extend axially (e.g. in the general direction of axis 332) from the corresponding support arm 312 towards the susceptor 302. The support pad 320 may comprise silicon carbide (SiC), such as a SiC coating. The support pads 320 can have one or more of the benefits and features of the support pads 220 described above.

The lift mechanism 308 includes a plurality of lift pin supports 344 that are each configured to support corresponding lift pins 336 during a lift operation of the substrate. Each lift pin 336 is substantially in a shape of a cylinder and is configured to fit through corresponding holes 340 in the susceptor 302.

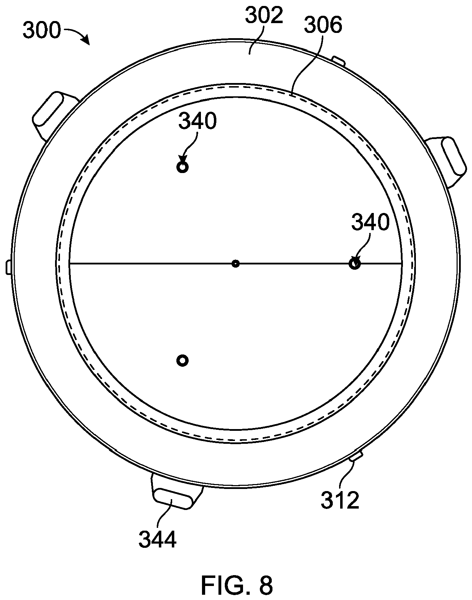

Figure 8 show top perspective views of the example substrate support and lift assembly 300, according to one embodiment. In Figure 8, the substrate support and lift assembly 300 is shown with the substrate 306 supported by the susceptor 302. Figure 8 shows the susceptor 302 optionally with the substrate 306 thereon, as shown in the broken line. The holes 340 of the susceptor 302 can be seen.

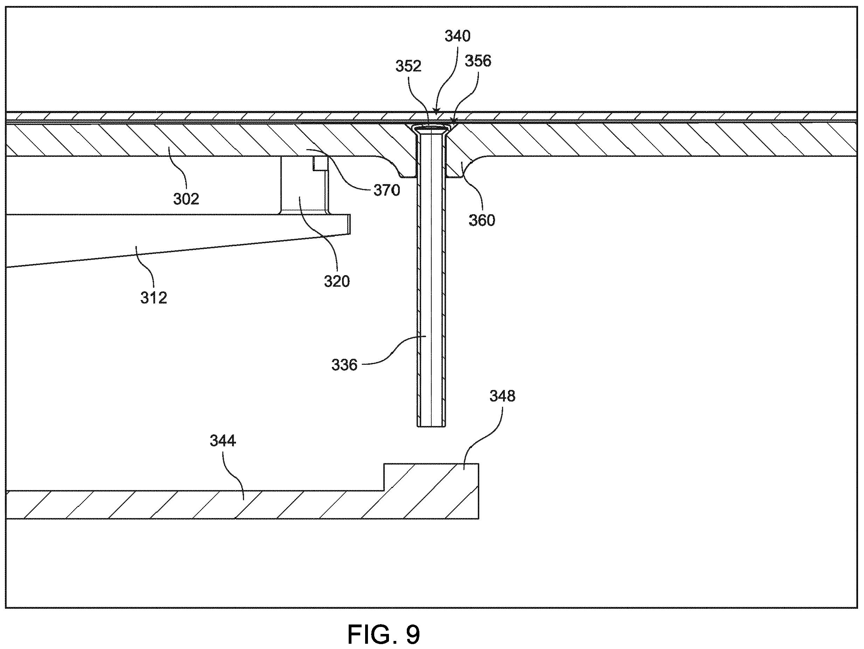

Figure 9 shows a cross-section of a side view of a portion of the substrate support and lift assembly 300. A portion of the susceptor 302, a support arm 312, and a lift pin support 344 can be seen. Unlike the cross-section view shown in Figure 5, the cross-section view shown in Figure 9 shows the support arm 312 extending partially into the page, because the support arm 312 is offset at an angle from the lift pin support 344 around axis 332 (see also Figures 7, 10, and 11). As such, support arm 312 is not substantially parallel to lift pin support 344. The cross section shows a hole 340 of the susceptor 302 as well as a corresponding hole rim 360 surrounding the hole 340. The hole rim 360 may be disposed on (e.g., extend from) an underside of the susceptor 302 and may be configured to provide additional support to the lift pin 336. The hole 340 and the associated hole rim 360 can be shaped to allow the lift pin 336 to fit therethrough but allow the lift pin head 352 to rest on a lift pin head slot 356 within the hole 340. The lift pin head slot 356 may be disposed within the top portion of the hole 340 and/or opposite the hole rim 360. The cross section of the lift pin head slot 356 may include a tapered section. The tapered section may be configured to allow the lift pin 336 to hang within the hole 340 when the lift pin 336 is not engaged with the lift pin support 344. The lift pin support 344 can include a lift pin support member 348 at or near a terminus of the lift pin support 344. In some embodiments, the lift pin support member 348 can include a raised platform that is configured to support the lift pin 336 thereon, such as the raised platform shown near the end of the lift pin support 244.

Figure 9 also shows the support pad 320 disposed on the support arm 312 and that is configured to support the susceptor 302 thereon. The support pad interface 370 of the susceptor 302 is shown. The support pad interface 370 is configured to receive the support pad 320 therein and to reduce slippage of the susceptor 302 relative to the support pad 320.

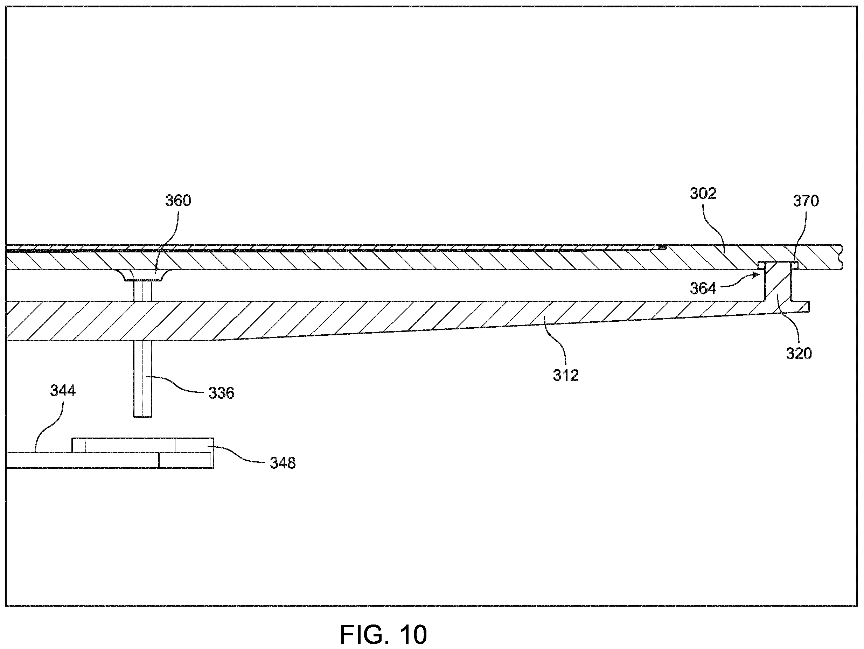

Figure 10 shows a cross-section of a different view of the portion of the substrate support and lift assembly 300 shown in Figure 9, but rotated about 60 degrees relative to Figure 9. As shown, a cross section of the support pad 320 and the support pad interface 370 at the support coupling 364 can be seen.

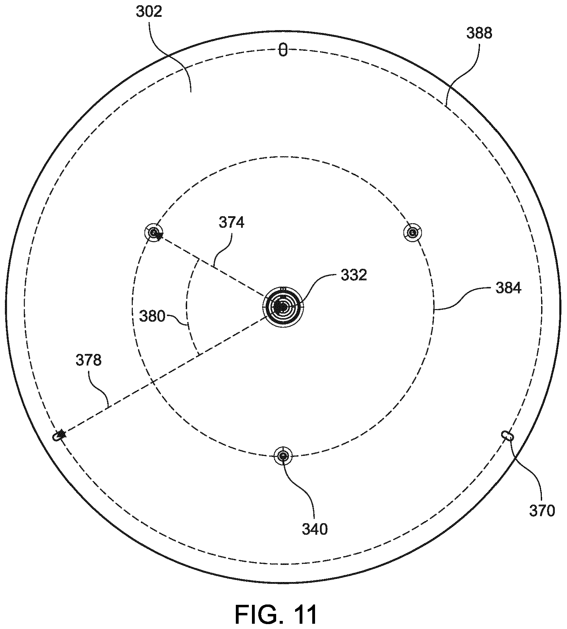

Figure 11 shows a bottom view of the susceptor 302. The support pad interfaces 370 are shown near an edge of the susceptor 302. As described above, the support pad interfaces 370 are configured to receive corresponding support pads 320. Unlike in the susceptor 202 shown in Figure 4, in some embodiments corresponding holes 340 and support pad interfaces 370 are not collinear with respect to each other along a radius extending from the center axis of the susceptor 302 but instead are angularly offset. The support pad interfaces 370 are shown nearer to the edge of the susceptor 302 than to either the corresponding holes 340 or to the center of the susceptor 302. Additionally or alternatively, the holes 340 may be disposed nearer to the support pad interfaces 370 than to either the edge of the susceptor or to the center of the susceptor 302 in certain embodiments.

Although this invention has been described in terms of certain embodiments, other embodiments that are apparent to those of ordinary skill in the art, including embodiments that do not provide all of the features and advantages set forth herein, are also within the scope of this invention. As will be appreciated by those with skill in the art that each of the individual variations described and illustrated herein has discrete components and features which may be readily separated from or combined with the features of any of the other several embodiments without departing from the scope or spirit of the present disclosure. For example, in some embodiments, a susceptor may have all of the various features disclosed herein (including the above-described ledge, pad, concavity, lobes, and thermocouple arrangement). In some embodiments, a susceptor may include only one or less than all of the above-describe features (e.g., only one or less than all of the above-described ledge, pad, concavity, lobes, and thermocouple arrangement). All such modifications are intended to be within the scope of claims associated with this disclosure.

### Examples

Below are a number of nonlimiting examples. They are provided by way of example only and should not be viewed as limiting any of the details described above.

In a 1st Example, a substrate support and lift assembly is configured to support and lift a substrate from a susceptor, the substrate support and lift assembly comprising: a susceptor support configured to support the susceptor thereon, the susceptor support comprising a plurality of support arms each extending radially from a central portion of the susceptor support to a terminus, each of the plurality of support arms comprising an aperture extending therethrough; and a lift pin configured to fit through the aperture of a corresponding support arm of the plurality of support arms to lift a substrate.

In a 2nd Example, the assembly of Example 1, further comprising a lift mechanism configured to lift the substrate from the susceptor, the lift mechanism comprising a plurality of lift pins, each lift pin configured to fit through corresponding apertures of the plurality of support arms.

In a 3rd Example, the assembly of any of Examples 1-2, wherein each aperture is disposed between the central portion of the susceptor support and a corresponding terminus.

In a 4th Example, the assembly of Example 3, further comprising a plurality of support pads, each support pad attached to a corresponding support arm and configured to extend toward and support the susceptor.

In a 5th Example, the assembly of Example 4, wherein each support pad is disposed nearer to a corresponding terminus than to a corresponding aperture.

In a 6th Example, the assembly of any of Examples 4-5, wherein each support pad comprises silicon carbide.

In a 7th Example, the assembly of any of Examples 1-6, wherein the plurality of support arms comprises at least three support arms.

In a 8th Example, the assembly of Example 7, wherein the plurality of support arms comprises exactly three support arms.

In a 9th Example, the assembly of Example 8, wherein each aperture extends along a vertical axis through a corresponding support arm.

In a 10th Example, the assembly of Example 9, wherein the lift pin is configured to fit through a hole of the susceptor.

In a 11th Example, the assembly of Example 10, further comprising the susceptor, wherein the susceptor and the susceptor support, and each of the apertures of the plurality of support arms and each of the corresponding holes of the susceptor, are configured to cooperate with each other such that a corresponding lift pin, when extended through the aperture and the hole, does not contact the susceptor at more than a first point of contact.

In a 12th Example, the assembly of any of Examples 10-11, wherein each of the support pads is disposed radially outward of each of the plurality of holes of the susceptor.

In a 13th Example, the assembly of any of Examples 1-12, wherein each aperture is disposed nearer to the terminus of a corresponding support arm than to the central portion of the susceptor support.

In a 14th Example, the assembly of any of Examples 1-13, wherein each of the plurality of support pads is disposed nearer to the terminus of a corresponding support arm than to a corresponding aperture of the support arm.

In a 15th Example, a substrate support assembly comprises: a susceptor configured to support a substrate, the susceptor having a plurality of holes each configured to receive a corresponding lift pin therethrough; a susceptor support configured to support the susceptor, the susceptor support comprising a plurality of support arms each extending radially from a central portion of the susceptor support, each of the plurality of support arms comprising an aperture, wherein each aperture is aligned with a corresponding hole of the susceptor.

In a 16th Example, the assembly of Example 15, further comprising a lift mechanism configured to lift the substrate from the susceptor, the lift mechanism comprising a plurality of lift pins, each lift pin configured to fit through corresponding apertures of the plurality of support arms.

In a 17th Example, the assembly of Example 16, wherein the lift pin is configured to fit through a hole of the susceptor.

In a 18th Example, the assembly of any of Examples 15-17, wherein each aperture is disposed between the central portion of the susceptor support and a terminus of a corresponding support arm.

In a 19th Example, the assembly of any of Examples 15-18, further comprising a plurality of support pads, each support pad attached to a corresponding support arm and configured to extend toward and support the susceptor.

In a 20th Example, the assembly of Example 19, wherein each support pad is disposed nearer to a corresponding terminus than to a corresponding aperture.

In a 21st Example, the assembly of any of Examples 19-20, wherein each support pad comprises silicon carbide.

In a 22nd Example, the assembly of any of Examples 19-21, wherein each of the support pads is disposed radially outward of each of the plurality of holes of the susceptor.

In a 23rd Example, the assembly of any of Examples 15-22, wherein the plurality of support arms comprises at least three support arms.

In a 24th Example, the assembly of Example 23, wherein the plurality of support arms comprises exactly three support arms.

In a 25th Example, the assembly of any of Examples 15-24, wherein each aperture extends along a vertical axis through a corresponding support arm.

In a 26th Example, the assembly of any of Examples 15-25, wherein the susceptor and the susceptor support, and each of the apertures of the plurality of support arms and each of the corresponding holes of the susceptor, are configured to cooperate with each other such that a corresponding lift pin, when extended through the aperture and the hole, does not contact the susceptor at more than a first point of contact.

In a 27th Example, the assembly of any of Examples 15-26, wherein each aperture is disposed nearer to a terminus of a corresponding support arm than to the central portion of the susceptor support.

In a 28th Example, a substrate support assembly comprises: a susceptor configured to support a substrate, the susceptor having a plurality of holes extending through a thickness of the susceptor, each hole configured to receive a corresponding lift pin therethrough; a susceptor support configured to support the susceptor, the susceptor support comprising a plurality of support arms each extending radially from a central portion of the susceptor support, each of the plurality of support arms comprising an aperture, wherein the susceptor and the susceptor support, and each of the apertures of the plurality of support arms and each of the corresponding holes of the susceptor, are configured to cooperate with each other such that a corresponding lift pin, when extended through the aperture and the hole, does not contact the susceptor at more than a first point of contact.

In a 29th Example, the assembly of Example 28, further comprising a lift mechanism configured to lift the substrate from the susceptor, the lift mechanism comprising a plurality of lift pins, each lift pin configured to fit through corresponding apertures of the plurality of support arms.

In a 30th Example, the assembly of Example 29, wherein each lift pin is configured to fit through a corresponding hole of the susceptor.

In a 31st Example, the assembly of any of Examples 28-30, wherein each aperture is disposed between the central portion of the susceptor support and a terminus of a corresponding support arm.

In a 32nd Example, the assembly of any of Examples 28-31, further comprising a plurality of support pads, each support pad attached to a corresponding support arm and configured to extend toward and support the susceptor.

In a 33rd Example, the assembly of Example 32, wherein each support pad is disposed nearer to a terminus of a corresponding support arm than to a corresponding aperture.

In a 34th Example, the assembly of any of Examples 32-33, wherein each support pad comprises silicon carbide.

In a 35th Example, the assembly of any of Examples 32-34, wherein each of the support pads is disposed radially outward of each of the plurality of holes of the susceptor.

In a 36th Example, the assembly of any of Examples 28-35, wherein the plurality of support arms comprises at least three support arms.

In a 37th Example, the assembly of Example 36, wherein the plurality of support arms comprises exactly three support arms.

In a 38th Example, the assembly of any of Examples 28-37, wherein each aperture extends along a vertical axis through a corresponding support arm.

In a 39th Example, the assembly of any of Examples 28-38, wherein the susceptor and the susceptor support, and each of the apertures of the plurality of support arms and each of the corresponding holes of the susceptor, are configured to cooperate with each other such that a corresponding lift pin, when extended through the aperture and the hole, does not contact the susceptor at more than a first point of contact.

In a 40th Example, the assembly of any of Examples 28-39, wherein each aperture is disposed nearer to the terminus of a corresponding support arm than to the central portion of the substrate support.

In a 41st Example, a substrate support and lift assembly configured to support and lift a substrate from a susceptor, the substrate support and lift assembly comprising: a susceptor having a plurality of holes, each hole configured to receive a lift pin from a lift mechanism; and a susceptor support configured to support the susceptor thereon, the susceptor support comprising a plurality of support arms each extending radially from a central portion of the susceptor support, each of the plurality of support arms comprising a support pad configured to extend toward and support the susceptor, each of the support pads disposed radially outward of each of the plurality of holes of the susceptor.

In a 42nd Example, the assembly of Example 41, further comprising a lift mechanism configured to lift a substrate from the susceptor, the lift mechanism comprising a plurality of lift pins each configured to extend axially from the lift mechanism and to fit through corresponding apertures of the plurality of support arms to lift the substrate.

In a 43rd Example, the assembly of Example 42, wherein each of the lift pins is disposed at a first radial distance from a central portion of the substrate support, and wherein each support pad of the plurality of support arms is disposed less than half of the first radial distance from an outer edge of the susceptor.

In a 44th Example, the assembly of Example 43, wherein each lift pin is configured to fit through a corresponding hole of the susceptor.

In a 45th Example, the assembly of any of Examples 41-44, further comprising a plurality of support pads, each support pad attached to a corresponding support arm and configured to extend toward and support the susceptor.

In a 46th Example, the assembly of Example 45, wherein each support pad is disposed nearer to a terminus of a corresponding support arm than to a corresponding aperture.

In a 47th Example, the assembly of any of Examples 45-46, wherein each support pad comprises silicon carbide.

In a 48th Example, the assembly of any of Examples 45-47, wherein each of the support pads is disposed radially outward of each of the plurality of holes of the susceptor.

In a 49th Example, the assembly of any of Examples 41-48, wherein the plurality of support arms comprises at least three support arms.

In a 50th Example, the assembly of Example 49, wherein the plurality of support arms comprises exactly three support arms.

In a 51st Example, the assembly of any of Examples 41-50, wherein each aperture extends along a vertical axis through a corresponding support arm.

In a 52nd Example, the assembly of any of Examples 41-51, wherein the susceptor and the susceptor support, and each of the apertures of the plurality of support arms and each of the corresponding holes of the susceptor, are configured to cooperate with each other such that a corresponding lift pin, when extended through the aperture and the hole, does not contact the susceptor at more than a first point of contact.

In a 53rd Example, the assembly of any of Examples 41-52, wherein each aperture is disposed nearer to a terminus of a corresponding support arm than to the central portion of the susceptor support.

In a 54th Example, a susceptor support is configured to support a susceptor thereon, the susceptor support comprising: a plurality of support arms each extending radially from a central portion of the susceptor support to a terminus, each of the plurality of support arms comprising an aperture extending therethrough, the aperture configured to receive a corresponding lift pin; and a plurality of support pads each attached to a corresponding support arm and configured to extend toward and support the susceptor, each of the support pads disposed radially outward of each of the plurality of holes of the susceptor.

In a 55th Example, the substrate support of Example 54, further comprising a lift mechanism configured to lift a substrate from the susceptor, the lift mechanism comprising a plurality of lift pins each configured to extend axially from the lift mechanism and to fit through corresponding apertures of the plurality of support arms to lift the substrate.

In a 56th Example, the substrate support of any of Examples 54-55, wherein each of the lift pins is disposed radially outward of each support pad of the plurality of support arms.

In a 57th Example, the substrate support of Example 56, wherein each of the lift pins is disposed at a first radial distance from the central portion of the substrate support, and wherein each support pad of the plurality of support arms is disposed less than half of the first radial distance from an outer edge of the susceptor.

In a 58th Example, the substrate support of Example 57, wherein each lift pin is configured to fit through a corresponding hole of the susceptor.

In a 59th Example, the substrate support of any of Examples 54-58, wherein each support pad is disposed nearer to a terminus of a corresponding support arm than to a corresponding aperture.

In a 60th Example, the substrate support of any of Examples 54-59, wherein each support pad comprises silicon carbide.

In a 61st Example, the substrate support of any of Examples 54-60, wherein each of the support pads is disposed radially outward of each of the plurality of holes of the susceptor.

In a 62nd Example, the substrate support of any of Examples 54-61, wherein the plurality of support arms comprises at least three support arms.

In a 63rd Example, the substrate support of any of Examples 54-62, wherein the plurality of support arms comprises exactly three support arms.

In a 64th Example, the substrate support of any of Examples 54-63, wherein each aperture extends along a vertical axis through a corresponding support arm.

In a 65th Example, the substrate support of any of Examples 54-64, wherein each aperture is disposed nearer to a terminus of a corresponding support arm than to the central portion of the susceptor support.

In a 66th Example, a susceptor is configured to support a substrate, the susceptor comprising: a plurality of holes extending through a thickness of the susceptor, each configured to receive a corresponding lift pin therethrough; and a plurality of support pad interfaces disposed on a lower surface of the susceptor and radially outward from the plurality of holes, the interfaces configured to engage with a support pad on a susceptor support.

In a 67th Example, the susceptor of Example 66, wherein each support pad interfaces is disposed nearer to an edge of the susceptor than to a corresponding hole.

In a 68th Example, the susceptor of any of Examples 66-67, wherein the plurality of support pad interfaces comprises at least three support pad interfaces.

In a 69th Example, the susceptor of any of Examples 66-68, wherein the plurality of support pad interfaces comprises exactly three support pad interfaces.

In a 70th Example, the susceptor of any of Examples 66-69, wherein each of the plurality of holes has a corresponding aperture of a susceptor support, and wherein each of the apertures and each of the corresponding holes of the susceptor are configured to cooperate with each other such that a corresponding lift pin, when extended through the aperture and the hole, does not contact the susceptor at more than a first point of contact.

In a 71st Example, a substrate support and lift assembly configured to support and lift a substrate from a susceptor, the substrate support and lift assembly comprising: a susceptor configured to support a substrate thereon; and a susceptor support configured to support the susceptor thereon, the susceptor support comprising a plurality of support arms each extending radially from a central portion of the susceptor support, each of the plurality of support arms configured to support the susceptor at corresponding support couplings, each of the support couplings disposed more than 90 mm from a center of the susceptor.

In a 72nd Example, the susceptor support of Example 71, wherein each of the support couplings are disposed less than about 200 mm from a center of the susceptor.

In a 73rd Example, the susceptor support of Example 72, wherein each of the support couplings are disposed between about 100 mm and about 175 mm from a center of the susceptor.

## Claims

1. A substrate support and lift assembly configured to support and lift a substrate from a susceptor, the substrate support and lift assembly comprising:
a susceptor support configured to support the susceptor thereon, the susceptor support comprising a plurality of support arms each extending radially from a central portion of the susceptor support to a terminus, each of the plurality of support arms comprising an aperture extending therethrough; and
a lift pin configured to fit through the aperture of a corresponding support arm of the plurality of support arms to lift a substrate.

2. The assembly of Claim 1, further comprising a lift mechanism configured to lift the substrate from the susceptor, the lift mechanism comprising a plurality of lift pins, each lift pin configured to fit through corresponding apertures of the plurality of support arms.

3. The assembly of according to Claim 1 or 2, wherein each aperture is disposed between the central portion of the susceptor support and a corresponding terminus.

4. The assembly of Claim 3, further comprising a plurality of support pads, each support pad attached to a corresponding support arm and configured to extend toward and support the susceptor.

5. The assembly of Claim 4, wherein each support pad is disposed nearer to a corresponding terminus than to a corresponding aperture.

6. The assembly of Claim 4 or 5, wherein each support pad comprises silicon carbide.

7. The assembly of according to any one of Claims 1-6, wherein the plurality of support arms comprises at least three support arms.

8. The assembly of Claim 7, wherein the plurality of support arms comprises exactly three support arms.

9. The assembly of Claim 8, wherein each aperture extends along a vertical axis through a corresponding support arm.

10. The assembly of Claim 9, wherein the lift pin is configured to fit through a hole of the susceptor.

11. The assembly of Claim 10, further comprising the susceptor, wherein the susceptor and the susceptor support, and each of the apertures of the plurality of support arms and each of the corresponding holes of the susceptor, are configured to cooperate with each other such that a corresponding lift pin, when extended through the aperture and the hole, does not contact the susceptor at more than a first point of contact.

12. The assembly of Claim 10 or 11, wherein each of the support pads is disposed radially outward of each of the plurality of holes of the susceptor.

13. The assembly according to any one of Claims 1-12, wherein each aperture is disposed nearer to the terminus of a corresponding support arm than to the central portion of the susceptor support.

14. The assembly according to any one of Claims 1-13, wherein each of the plurality of support pads is disposed nearer to the terminus of a corresponding support arm than to a corresponding aperture of the support arm.

15. A substrate support assembly comprising:
a susceptor configured to support a substrate, the susceptor having a plurality of holes each configured to receive a corresponding lift pin therethrough;
a susceptor support configured to support the susceptor, the susceptor support comprising a plurality of support arms each extending radially from a central portion of the susceptor support, each of the plurality of support arms comprising an aperture, wherein each aperture is aligned with a corresponding hole of the susceptor.

16. The assembly of Claim 15, further comprising a lift mechanism configured to lift the substrate from the susceptor, the lift mechanism comprising a plurality of lift pins, each lift pin configured to fit through corresponding apertures of the plurality of support arms.

17. The assembly of Claim 16, wherein the lift pin is configured to fit through a hole of the susceptor.

18. The assembly according to any one of Claims 15-17, wherein each aperture is disposed between the central portion of the susceptor support and a terminus of a corresponding support arm.

19. The assembly according to any one of Claims 15-18, further comprising a plurality of support pads, each support pad attached to a corresponding support arm and configured to extend toward and support the susceptor.

20. A substrate support assembly, the assembly comprising:
a susceptor configured to support a substrate, the susceptor having a plurality of holes extending through a thickness of the susceptor, each hole configured to receive a corresponding lift pin therethrough;
a susceptor support configured to support the susceptor, the susceptor support comprising a plurality of support arms each extending radially from a central portion of the susceptor support, each of the plurality of support arms comprising an aperture, wherein the susceptor and the susceptor support, and each of the apertures of the plurality of support arms and each of the corresponding holes of the susceptor, are configured to cooperate with each other such that a corresponding lift pin, when extended through the aperture and the hole, does not contact the susceptor at more than a first point of contact.
